# EUROPEAN PATENT APPLICATION

(11) **EP 2 403 324 A2**
(43) Date of publication of application: **04.01.2012**
(21) Application number: 11171678.3
(22) Date of filing: 28.06.2011
(51) Int. Cl.: H05K 1/05, H05K 1/02, H05K 3/24, H01L 27/15, H01L 33/60, F21K 99/00

(54) **Light-emitting module and illumination device**

(30) Priority: 30.06.2010 JP 2010150420
(71) Applicant: Toshiba Lighting & Technology Corporation, Yokosuka-shi Kanagawa 237-8510 (JP)
(72) Inventor: Sanpei, Tomohiro, Kanagawa, 237-8510 (JP); Takenaka, Erika, Kanagawa, 237-8510 (JP)
(74) Representative: Bokinge, Ole

(57) **Abstract**

According to one embodiment, a light-emitting module (6) includes a module substrate (25), a light-reflecting layer (28), and a light-emitting element (41). The light-reflecting layer (28) is superposed on the module substrate (25) and has a reflection ratio higher than the reflection ratio of the module substrate (25). The light-emitting element (41) is mounted on the module substrate (25). The light-reflecting layer (28) includes a copper layer (31a), a copper plating layer (31b) which covers the copper layer (31a), and a metal layer (32, 33) which is superposed on the copper plating layer (31b) and reflects light emitted from the light-emitting element (41).

## Description

### FIELD

Embodiments described herein relate generally to a light-emitting module, in which semiconductor light-emitting elements such as light-emitting diodes are mounted on a light-reflecting layer, and an illumination device provided with the light-emitting module.

### BACKGROUND

Light-emitting modules of chip-on-a-board (COB) type are used as the light sources of LED lamps and the like. Light-emitting modules of this type include a module substrate, and a plurality of light-emitting diodes mounted on the module substrate. The module substrate is formed of white epoxy resin, into which glass powder or the like is mixed, to obtain good light reflectance.

In prior art, to effectively extract light emitted from the light-emitting diodes, it is attempted to superpose a light-reflecting layer formed of silver on the module substrate. The light-reflecting layer is used for reflecting light emitted from the light-emitting diodes toward the module substrate in an original direction in which the light should be extracted, and the light-reflecting layer is at least provided in a position which corresponds to the light-emitting diodes.

The light-reflecting layer which reflects light emitted from the light-emitting diodes is required to maintain good light reflection efficiency for a long time. However, in light-emitting modules of prior art, reflectance of light of a wavelength of 460 nm remains at about 88%. Therefore, there is room for compromise, from the viewpoint of more efficiently extracting light emitted from light-emitting diodes.

### BRIEF DESCRIPTION OF THE DRAWINGS

FIG. 1 is an exemplary perspective view of an LED lamp according to an embodiment;
FIG. 2 is an exemplary cross-sectional view of the LED lamp according to the embodiment;
FIG. 3 is an exemplary plan view of a light-emitting module according to the embodiment;
FIG. 4 is an exemplary cross-sectional view of the light-emitting module according to the embodiment;
FIG. 5 is an exemplary cross-sectional view of a light-reflecting layer according to the embodiment;
FIG. 6 is an exemplary characteristic diagram illustrating the relationship between the wavelength and the reflection ratio in the LED lamp according to the embodiment;
FIG. 7 is an exemplary characteristic diagram illustrating the relationship between the thickness of the silver plating layer and the reflection ratio in the LED lamp according to the embodiment; and
FIG. 8 is an exemplary characteristic diagram illustrating a result of improvement in reflection ratio in the LED lamp according to the embodiment.

### DETAILED DESCRIPTION

In general, according to one embodiment, a light-emitting module comprises a module substrate, a light-reflecting layer, and a light-emitting element. The light-reflecting layer is superposed on the module substrate, and has a reflection ratio higher than that of the module substrate. The light-emitting element is mounted on the module substrate. The light-reflecting layer includes a copper layer, a copper plating layer which covers the copper layer, and a metal layer which is superposed on the copper plating layer and reflects light emitted from the light-emitting element.

In a light-emitting module according to a first aspect, the module substrate is formed of an insulating material such as a synthetic resin and ceramics. The module substrate may be formed of a single layer or a plurality of layers, and may include a metal plate to further enhance heat radiation property.

As the light-emitting element, it is possible to use, for example, light-emitting diodes formed of a bare chip. Each of the light-emitting diodes of this type has a pair of electrodes, and is bonded on the light-reflecting layer by using a die bond material which has light transmittance. The light-emitting diodes are arranged at intervals according to a predetermined rule. Adjacent light-emitting diodes are electrically connected through bonding wires.

The light-reflecting layer is used for reflecting light emitted from the light-emitting elements toward the module substrate, and effectively extracting the light from the light-emitting module. The light-reflecting layer may have a size on which the light-emitting elements can be mounted, or a size which corresponds to the individual light-emitting elements.

In addition, the copper layer which is a constituent element of the light-reflecting layer is formed by superposing a copper foil on the module substrate, and subjecting the copper foil to etching. Although no depressions or projections or stains are found on a surface of the copper foil when viewed with the naked eye, minute scratches and stains which are produced in manufacturing adhere to the surface of the copper foil when viewed under a microscope. Therefore, the surface of the copper layer which is formed of the copper foil is a rough surface which includes a number of depressions and projections. Since a rough surface diffusely reflects or disperses light which is made incident thereon, it is undeniable that the rough surface serves as an obstacle to reflection of light in a desired direction.

The copper plating layer covers the copper layer to fill the minute depressions and projections existing on the surface of the copper layer. Therefore, the surface of the copper plating layer is a flat and smooth surface, and thus a surface of the metal layer which is superposed on the copper plating layer is formed as a smooth surface.

The copper plating layer can be formed by subjecting the copper layer to electrolytic plating. A thickness of the copper plating layer is desirably smaller than the thickness of the copper layer, specifically 2 µm or more.

According to the light-emitting module of the first aspect, the metal layer has a smooth surface by virtue of the existence of the copper plating layer, and thus the reflection ratio of the light-reflecting layer is improved. As a result, light emitted from the light-emitting element can be efficiently reflected in a light-extracting direction.

According to a light-emitting module of a second aspect, the metal layer includes a nickel plating layer which is superposed on the copper plating layer, and a silver plating layer which is superposed on the nickel plating layer. The silver plating layer forms a light-reflecting surface which reflects the light emitted from the light-emitting element.

According to the second aspect, both the nickel plating layer and the silver plating layer are formed of electrolytic plating. A coating obtained by electrolytic plating has a high single metal content by percentage, and thus has excellent corrosion resistance.

The nickel plating layer is interposed between the silver plating layer and the copper plating layer, and functions as a shield which prevents a copper component from diffusing into the silver plating layer. Therefore, it is possible to suppress discoloration of the silver plating layer, and prevent decrease in the reflection ratio of the silver plating layer. Thus, it is possible to maintain good light reflectance of the light-reflecting surface.

In addition, it is possible to limit roughness of the light-reflecting surface formed of the silver plating layer, that is, the maximum height of the depressions and projections existing on the light-reflecting surface as viewed under a microscope, to 1 µm or less. Consequently, it is possible to suppress scattering and absorption of light on the light-reflecting surface, and improve the light extracting efficiency.

According to a light-emitting module of a third aspect, the thickness of the silver plating layer is set to 2 µm or more. According to the third aspect, light of the light-emitting element, which is made incident on the silver plating layer is not easily transmitted through the silver plating layer. Therefore, it is possible to maintain a good reflection ratio of the light-reflecting surface. Therefore, it is possible to efficiently extract light, which is emitted from the light-emitting elements toward the light-reflecting layer, out of the light-emitting module.

According to a light-emitting module of a fourth aspect, the copper plating layer is formed thinner than the copper layer. According to the fourth aspect, it is possible to shorten a work time required for forming the copper plating layer, and reduce the cost required for a plating process. In addition, when a copper foil is used as a material of the copper layer, it is possible to more reduce the manufacturing cost of the light-reflecting layer to secure the thickness by adding a copper plating layer to the copper foil, than the case of using a copper foil which has a thickness including the copper plating layer.

An illumination device according to a fifth aspect comprises: a light-emitting module according to any one of the first to fourth aspect; a body which supports the light-emitting module; and a lighting device which is provided in the body and lights the light-emitting module.

In the fifth aspect, the illumination device is an LED lamp which is compatible with an incandescent lamp and a bulb-type fluorescent lamp, or an illumination structure such as a spotlight and a streetlamp, and uses the light-emitting module as a light source.

According to the illumination device of the fifth aspect, the metal layer has a smooth surface, and the reflection ratio is improved. As a result, it is possible to efficiently extract the light emitted from the light-emitting element out of the light-emitting module. Therefore, sufficient brightness for general illumination is obtained.

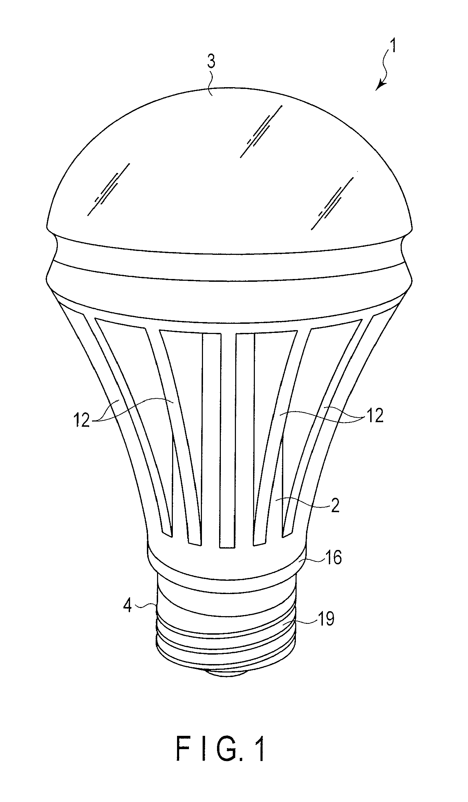

An embodiment 1 of the illumination device will be explained hereinafter based on FIG. 1 to FIG. 8.

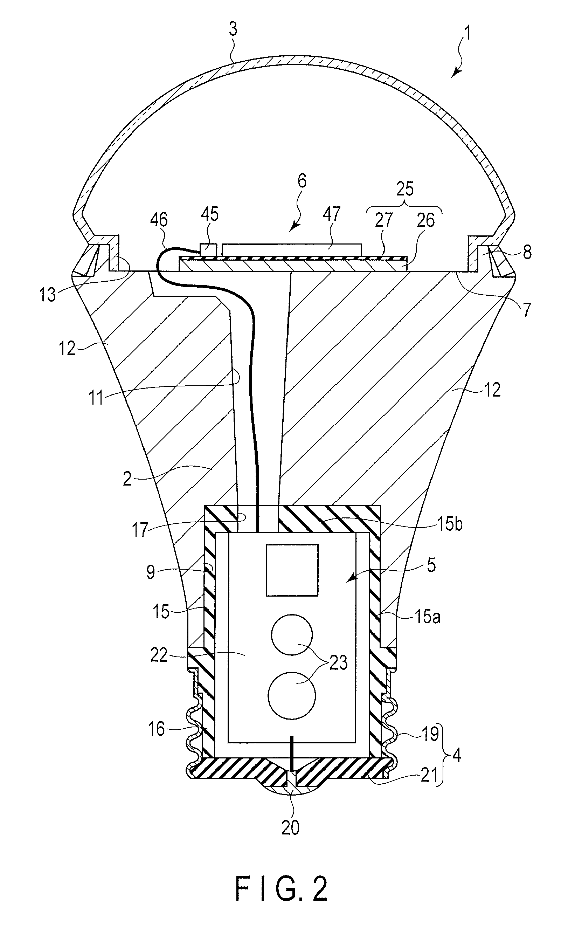

FIG. 1 and FIG. 2 disclose an LED lamp 1 which is an example of the illumination device. LED lamp 1 comprises a lamp body 2, a translucent cover 3, an E-shaped base 4, a lighting device 5, and a chip-on-a board (COB) light-emitting module 6.

The lamp body 2 is formed of a metal material such as aluminum. The lamp body 2 has a tube shape which has a flat support surface 7 at one end. A ring-shaped support wall 8 is formed as one unitary piece on an outer edge part of the support surface 7. The lamp body 2 includes a concave part 9 at the other end which is opposite to the support surface 7. In addition, a through-hole 11 which extends in an axial direction of the lamp body 2 is formed inside the lamp body 2. One end of the through-hole 11 is opened to the support surface 7. The other end of the through-hole 11 is opened to a bottom of the concave part 9.

The lamp body 2 includes a plurality of thermally radiative fins 12. The thermally radiative fins 12 radially project from an outer peripheral surface of the lamp body 2. In addition, the thermally radiative fins 12 project toward the outside along the radial direction of the lamp body 2, as they go from the other end of the lamp body 2 toward one end.

The translucent cover 3 is formed in an almost hemispherical shape of, for example, a milky-white synthetic resin material. The translucent cover 3 includes an opening edge part 13 which is opened to the support surface 7 of the lamp body 2. The translucent cover 3 is connected to the lamp body 2 by fitting the opening edge part 13 into the support wall 8. The translucent cover 3 covers the support surface 7 of the lamp body 2.

As illustrated in FIG. 2, a base support 15 which is electrically non-conducting is attached to the concave part 9 of the lamp body 2. The base support 15 includes a cylindrical circumferential wall 15a, and an end wall 15b which closes one end of the circumferential wall 15a.

The circumferential wall 15a is fitted into the concave part 9, and covers an internal circumferential surface of the concave part 9. The circumferential wall 15a includes a projecting part 16 which projects from the concave part 9 to the outside of the lamp body 2. The end wall 15b covers the bottom of the concave part 9, and includes a through-hole 17 which agrees with the through-hole 11. In addition, an internal space of the base support 15 connects to the support surface 7 of the lamp body 2 through the through-hole 17 and the through-hole 11.

The base 4 is formed of a metal shell 19, and an insulator 21 which includes an eyelet terminal 20. The shell 19 is attached to the projecting part 16 of the base support 15 to cover the projecting part 16 from outside. The insulator 21 abuts the opening end part of the projecting part 16, and closes the internal space of the base support 15.

The lighting device 5 is contained in the internal space of the base support 15. The lighting device 5 includes a circuit board 22, and a plurality of circuit components 23 such as a transformer, a capacitor, and a transistor, which are mounted on the circuit board 22. The lighting device 5 is electrically connected to the base 4.

The light-emitting module 6 is used as a light source of the LED lamp 1. The light-emitting module 6 is attached to the support surface 7 of the lamp body 2, and covered with the translucent cover 3.

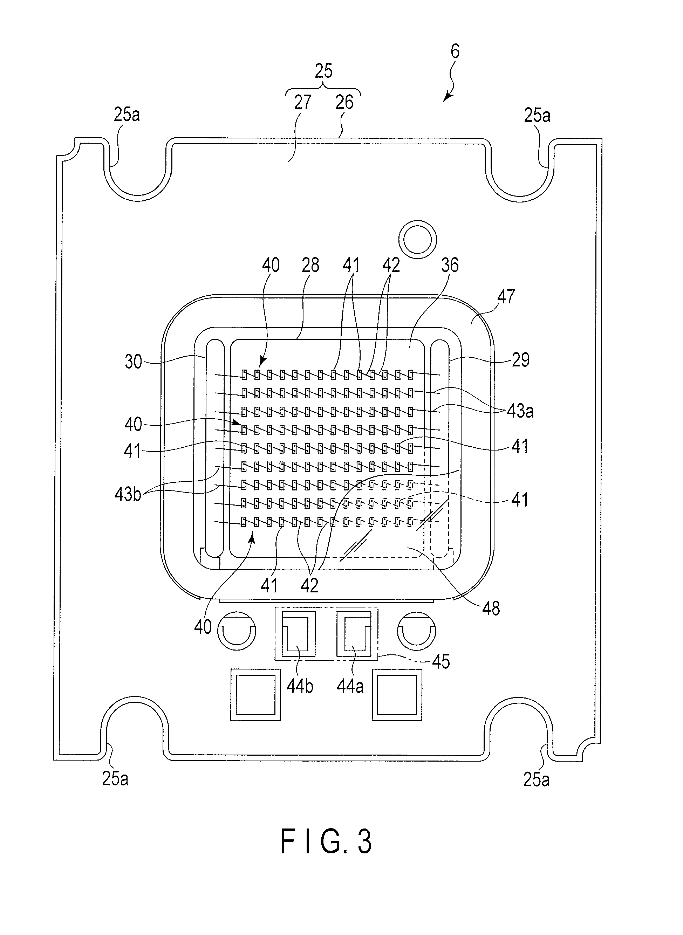

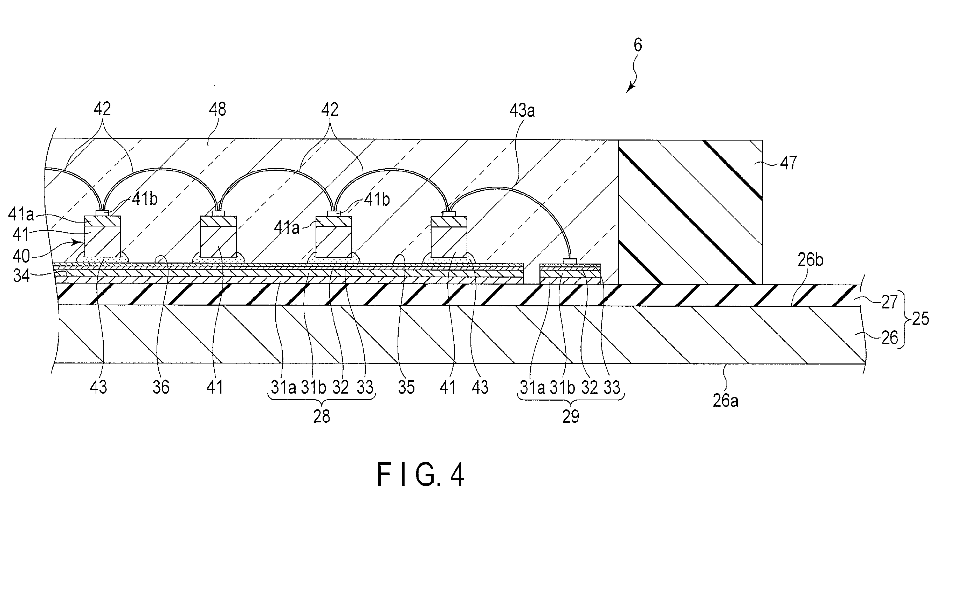

As illustrated in FIG. 3 and FIG. 4, the light-emitting module 6 includes a module substrate 25. The module substrate 25 has a rectangular shape which has four corners. The module substrate 25 includes four cutaway parts 25a. The cutaway parts 25a are located around the respective corners of the module substrate 25.

The module substrate 25 is formed of a metal base 26 and an insulating layer 27. The base 26 is formed in a rectangular plate shape by using aluminum or aluminum alloy. The base 26 includes a first surface 26a and a second surface 26b. The second surface 26b is located reverse to the first surface 26a, and forms a front surface of the base 26.

The insulating layer 27 is superposed on the second surface 26b of the base 26, and covers the whole second surface 26b. The insulating layer 27 is formed of, for example, epoxy resin of glycidyl ester-type, linear aliphatic epoxide-type, or alicyclic epoxide-type.

The module substrate 25 is fixed in the center of the support surface 7 of the lamp body 2 by four screws. The screws pass through the cutaway parts 25a of the module substrate 25 and driven into the lamp body 2. Thereby, the first surface 26a of the base 26 is brought into close contact with the support surface 7, and the module substrate 25 is thermally connected to the lamp body 2.

As illustrated in FIG. 3 and FIG. 4, a light-reflecting layer 28, a first power-supply conductor 29, and a second power-supply conductor 30 are superposed on the insulating layer 27 of the module substrate 25. The light-reflecting layer 28 has a rectangular shape which has four sides, and is located in the center of the insulating layer 27.

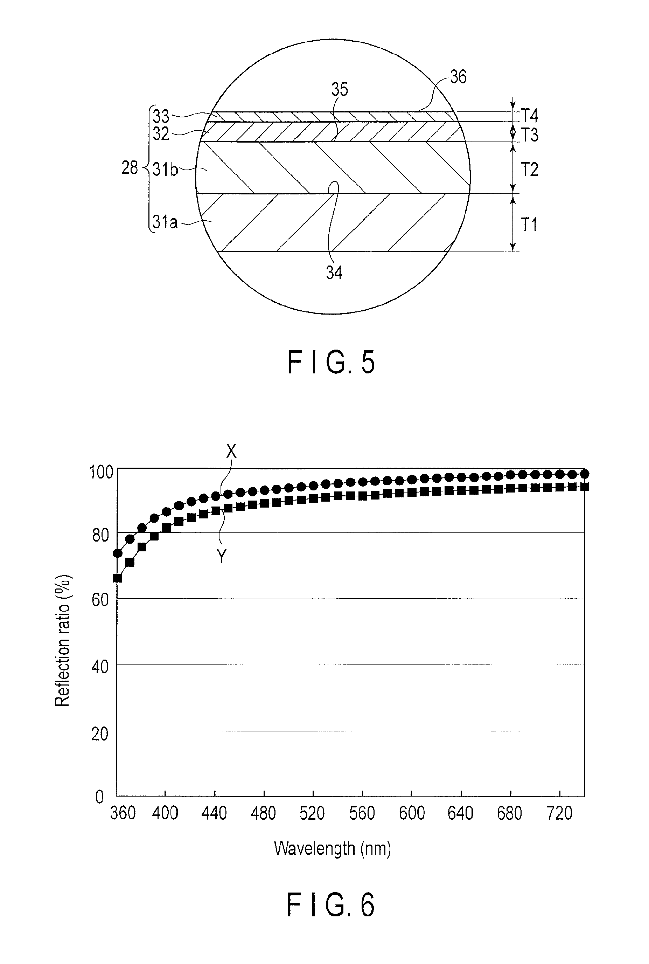

As illustrated in FIG. 5, the light-reflecting layer 28 adopts a four-layer structure, which is formed by superposing a copper layer 31a, a copper plating layer 31b, a nickel plating layer 32, and a silver plating layer 33. The copper layer 31a is formed of a copper foil which is superposed on the insulating layer 27 of the module substrate 25.

Although a surface of the copper foil is smooth as viewed with the naked eye, minute scratches and stains which are produced in manufacturing adhere to the surface of the copper foil as closely viewed under a microscope. Therefore, a surface 34 of the copper layer 31a formed of the copper foil is a rough surface which has a number of minute depressions and projections. The depth of the depressions and projections which form the rough surface is generally 1 µm to 2 µm. The rough surface diffusely reflects or scatters light which is made incident on the rough surface, and thus the light reflecting direction fluctuates.

The copper plating layer 31b is formed by subjecting the copper foil superposed on the insulating layer 27 to electrolytic plating. The copper plating layer 31b covers the surface 34 of the copper layer 31a. Thereby, the minute depressions and projections existing on the surface 34 of the copper layer 31a are filled with the copper plating layer 31b. The depth of the depressions and projections existing on the surface 34 of the copper layer 31a is generally about 1 µm to 2 µm. Therefore, the copper plating layer 31b is required to have a thickness of 2 µm or more which is larger than the depth of the depressions and projections.

In Embodiment 1, the copper layer 31a has a thickness T1 of 18 µm, and the copper plating layer 31b has a thickness T2 of 17 µm. Therefore, a surface 35 of the copper plating layer 31b is not influenced by the depressions and projections of the copper layer 31a, and is flat even when viewed under a microscope.

According to Embodiment 1, the copper layer 31a is formed in a rectangular shape by subjecting the copper foil to electrolytic plating and then etching. The copper layer 31a and the copper plating layer 31b form an underlayer of the light-reflecting layer 28 in cooperation with each other. The underlayer has a thickness of 35 µm.

The nickel plating layer 32 and the silver plating layer 33 are an example of a metal layer. The nickel plating layer 32 is formed by subjecting the copper plating layer 31b to electrolytic plating. The nickel plating layer 32 covers the smooth surface 35 of the copper plating layer 31b. The nickel plating layer 32 has a thickness T3 of, for example, 5 µm.

The silver plating layer 33 is formed by subjecting the nickel plating layer 32 to electrolytic plating. The silver plating layer 33 covers the nickel plating layer 32, and forms a surface layer of the light-reflecting layer 28. A thickness T4 of the silver plating layer 33 is desirably 2 µm or more.

Therefore, the surface of the light-reflecting layer 28 is a silver light-reflecting surface 36. The reflection ratio of the light-reflecting surface 36 is higher than the reflection ratio of the insulating layer 27 of the module substrate 25.

As illustrated in FIG. 3, each of the first and second power-supply conductors 29 and 30 has an elongated shape which extends along a side of the light-reflecting layer 28. The first and second power-supply conductors 29 and 30 are arranged parallel and apart from each other to hold the light-reflecting layer 28 therebetween, and are electrically insulated from each other.

The first and second power-supply conductors 29 and 30 are formed on the insulating layer 27 simultaneously with the light-reflecting layer 28. The first and second power-supply conductors 29 and 30 adopt a four-layer structure which is similar to that of the light-reflecting layer 28. Specifically, each of the first and second power-supply conductors 29 and 30 is formed by etching the copper foil which is covered with the copper plating layer 31b, and then successively superposing the nickel plating layer 32 and the silver plating layer 33 on the copper plating layer 31b. Therefore, each of surface layers of the first and second power-supply conductors 29 and 30 is formed of silver.

As illustrated in FIG. 3, a plurality of light-emitting diode columns 40 are mounted on the light-reflecting surface 36 of the light-reflecting layer 28. The light-emitting diode columns 40 extend in straight lines in a direction perpendicular to the first and second power-supply conductors 29 and 30, and are arranged parallel at intervals.

Each of the light-emitting diode columns 40 includes a plurality of light-emitting diodes 41 and a plurality of first bonding wires 42. The light-emitting diodes 41 are an example of light-emitting elements. Each of the light-emitting diodes 41 is formed of a bare chip which includes a light-emitting layer 41a which emits, for example, blue light. Each light-emitting diode 41 has a rectangular shape in a plan view, the longer sides thereof have a length of, for example, 0.5 mm, and the shorter sides thereof have a length of 0.25 mm. Each light-emitting diode 41 includes a pair of electrodes 41b, which have different polarities, on the light-emitting layer 41a. FIG. 4 illustrates only one of the electrodes 41b in each light-emitting diode 41.

Each light-emitting diode 41 is bonded to the light-reflecting surface 36 by using a translucent die bond material 43. In addition, the light-emitting diodes 41 of each light-emitting diode column 40 are arranged at intervals in a line in the direction perpendicular to the first and second power-supply conductors 29 and 30. As a result, as illustrated in FIG. 3, the light-emitting diodes 41 are regularly arranged in rows and columns to spread over a wide range of the light-reflecting surface 36.

In other words, the light-reflecting surface 36 has a sufficient size on which all the light-emitting diodes 41 can be bonded together. Therefore, the light-reflecting surface 36 continues between adjacent light-emitting diodes 41 without a break.

Each first bonding wire 42 electrically connects light-emitting diodes 41, which are adjacent in a direction where the light-emitting diode column 40 extends, in series. Specifically, each first bonding wire 42 extends over adjacent light-emitting diodes 41 to connect the electrodes 41b having different polarities of the adjacent light-emitting diodes 41.

One end of each light-emitting diode column 40 is electrically connected to the first power-supply conductor 29 through a second bonding wire 43a. In the same manner, the other end of each light-emitting diode column 40 is electrically connected to the second power-supply conductor 30 through a third bonding wire 43b. Therefore, the light-emitting diode columns 40 are electrically connected to the first and second power-supply conductor 29 and 30 in parallel.

As illustrated in FIG. 3, a pair of power-supply terminals 44a and 44b are arranged on the insulating layer 27 of the module substrate 25. The power-supply terminals 44a and 44b are arranged in a position out of the light-reflecting surface 36. One power-supply terminal 44a is electrically connected to the first power-supply conductor 29 through a conductor pattern (not shown). The other power-supply terminal 44b is electrically connected to the second power-supply conductor 30 through a conductor pattern (not shown).

In addition, a connector 45 is soldered to the power-supply terminals 44a and 44b. The connector 45 is electrically connected to the lighting device 5 through a coated electrical wire 46 illustrated in FIG. 2. The coated electrical wire 46 is guided to the internal space of the base 4, through the through-hole 11 of the lamp body 2 and the through-hole 17 of the base support 15.

As illustrated in FIG. 3 and FIG. 4, a frame member 47 is fixed to the insulating layer 27. The frame member 47 is formed of an insulating material such as synthetic resin, and encloses the light-reflecting layer 28, and the first and second power-supply conductors 29 and 30 all together. In other words, the light-emitting diodes 41, and the first to third bonding wires 42, 43a, and 43b are contained in a rectangular area enclosed by the frame member 47.

A sealing material 48 fills the area enclosed by the frame member 47. The sealing material 48 is formed of a translucent resin material such as a transparent silicone resin. The resin material in a liquid state is injected into the area enclosed by the frame member 47. The sealing material 48 injected into the area is heated and dried, and thereby hardened.

As a result, the sealing material 48 is superposed on the insulating layer 27 to cover the light-reflecting layer 28, the first power-supply conductor 29, the second power-supply conductor 30, the light-emitting diodes 41, and the first to third bonding wires 42, 43a, and 43b.

In Embodiment 1, a fluorescent material is mixed into the sealing material 48. The fluorescent material is uniformly dispersed in the sealing member 48. As the fluorescent material, yellow fluorescent material which is excited by blue light emitted by the light-emitting diodes 41 and emits yellow light is used.

The fluorescent material mixed into the sealing material 48 is not limited to yellow fluorescent material. For example, red fluorescent material which is excited by blue light and emits red light or green fluorescent material which emits green light may be added to the sealing member 48, to improve color rendering properties of the light emitted by the light-emitting diodes 41.

In the LED lamp 1 having the above structure, a voltage is applied to the light-emitting module 6 through the lighting device 5. Consequently, the light-emitting diodes 41 on the light-reflecting layer 28 emit light all together. Blue light emitted by the light-emitting diodes 41 is made incident on the sealing member 48. Part of the blue light which is made incident on the sealing member 48 is absorbed into the yellow fluorescent material. The rest of the blue light does not collide with the yellow fluorescent material, but passes through the sealing material 48.

The yellow fluorescent material which has absorbed the blue light is excited and emits yellow light. The yellow light passes through the sealing material 48. Consequently, the yellow light and the blue light are mixed together inside the sealing material 48 to produce white light. The white light is radiated from the sealing member 48 toward the translucent cover 3. Therefore, the sealing material 48 which fills the area enclosed by the frame member 47 functions as a surface light-emitting part.

Light which is emitted from the light-emitting diodes 41 toward the module substrate 25 is reflected by the light-reflecting surface 36 of the light-reflecting layer 28, and surfaces of the first and second power-supply conductors 29 and 30, and goes toward the translucent cover 3. Consequently, most of the light emitted from the light-emitting diodes 41 is transmitted through the translucent cover 3 and used for illumination.

Heat of the light-emitting diodes 41, which is produced when the light-emitting diodes 41 emit light, is conducted to the light-reflecting layer 28 which includes the four layers. The light-reflecting layer 28 functions as a heat spreader which spreads heat of the light-emitting diodes 41 over a wide range. In addition, the heat of the light-emitting diodes 41, which is spread by the light-reflecting layer 28 is conducted to the metal base 26 through the insulating layer 27, and conducted to the support surface 7 of the lamp body 2 through the base 26. The heat conducted to the lamp body 2 is discharged from the thermally radiative fins 12 to the outside of the LED lamp 1.

Consequently, heat of the light-emitting diodes 41 can be actively released from the module substrate 25 to the lamp body 2. Therefore, it is possible to enhance the heat radiation property of the light-emitting diodes 41, and maintain good luminous efficacy of the light-emitting diodes 41.

According to the light-emitting module 6 having the above structure, the surface of the copper foil which is used as the material of the copper layer 31a is a rough surface which includes a number of minute depressions and projections due to minute scratches and stains produced in manufacturing. The rough surface reflects diffusely or scatters light which is made incident on the rough surface, and thus serves as an obstacle to reflection of light in a desired direction.

In Embodiment 1, the surface 34 of the copper layer 31a is coated with the copper plating layer 31b. The copper plating layer 31b covers the copper layer 31a to fill minute depressions and projections existing on the surface 34 of the copper layer 31a. Therefore, the surface 35 of the copper plating layer 31b, which serves as an underlayer of the light-reflecting layer 28 is difficult to be influenced by the depressions and projections, and smoothness of the surface 35 of the copper plating layer 31b is increased. Therefore, the surfaces of the nickel plating layer 32 and the silver plating layer 33 which are superposed on the copper plating layer 31b are formed as smooth surfaces.

As a result, the light-reflecting surface 36 of the silver plating layer 33 is formed as flat and smooth surface. Therefore, the reflection ratio of the light-reflecting surface 36 is improved, and light emitted from the light-emitting diodes 41 can be efficiently reflected.

According to inspection by the inventor(s), when the light-reflecting surface 36 formed of the silver plating layer 33 was viewed under a microscope, it was found that the maximum height of the depressions and projections formed on the light-reflecting surface 36 was limited to 1 µm or less, and smoothness of the light-reflecting surface 36 was remarkably improved. Increase in smoothness of the light-reflecting surface 36 can suppress scattering and absorption of light by the depressions and projections, and improves light extracting efficiency.

Specifically, for example, supposing that the light extracting efficiency in the case where the height of the depressions and projections on the light-reflecting surface 36 is larger than 1 µm is 100%, the light-reflecting surface 36 in which the height of the depressions and projections is 1 µm or less can achieve light extracting efficiency of 110%.

In addition, in Embodiment 1, the nickel plating layer 32 is interposed between the copper plating layer 31b and the silver plating layer 33. The nickel plating layer 32 functions as a shield which prevents a copper component serving as an underlayer from diffusing into the silver plating layer 33. This structure suppresses discoloration of the silver plating layer 33, and prevents a decrease in the reflection ratio of the light-reflecting surface 36. Consequently, it is possible to maintain an original light reflection property of the light-reflecting surface 36 for a long time.

Therefore, the LED lamp 1 which includes the light-emitting module 6 as a light source can efficiently extract light emitted from the light-emitting module 6 out of the translucent cover 3, and can obtain sufficient brightness as general illumination.

The inventor(s) performed the following experiment to verify superiority of the light-reflecting layer 28 in which the copper layer 31a is coated with the copper plating layer 31b.

In the experiment, prepared were a light-emitting module which includes a light-reflecting layer formed of four layers as in Embodiment 1, and a light-emitting module which includes a three-layer light-reflecting layer that is formed by directly superposing a nickel plating layer and a silver plating layer on a copper layer formed of a copper foil as a comparative example. Then, the reflection ratio of the light-reflecting layer of each of the light-emitting modules was measured.

FIG. 6 illustrates a result of measurement of the reflection ratios of the above two light-emitting modules. A reference symbol X in FIG. 6 indicates the reflection ratio of the light-reflecting layer of Embodiment 1, and a reference symbol Y indicates the reflection ratio of the light-reflecting layer of the comparative example. As is clear from FIG. 6, the reflection ratio of the light-reflecting layer of Embodiment 1 is higher than that of the comparative example in all the wavelength regions. In particular, when the blue light reflection ratio of wavelength of 460 nm is considered, the reflection ratio in the comparative example is limited to 88%, while the reflection ratio in Embodiment 1 is 92%.

This shows that the reflection ratio of the light-reflecting layer is improved by about 4%, in the light-emitting module of Embodiment 1 in which the copper plating layer is added to the underlayer of the light-reflecting layer.

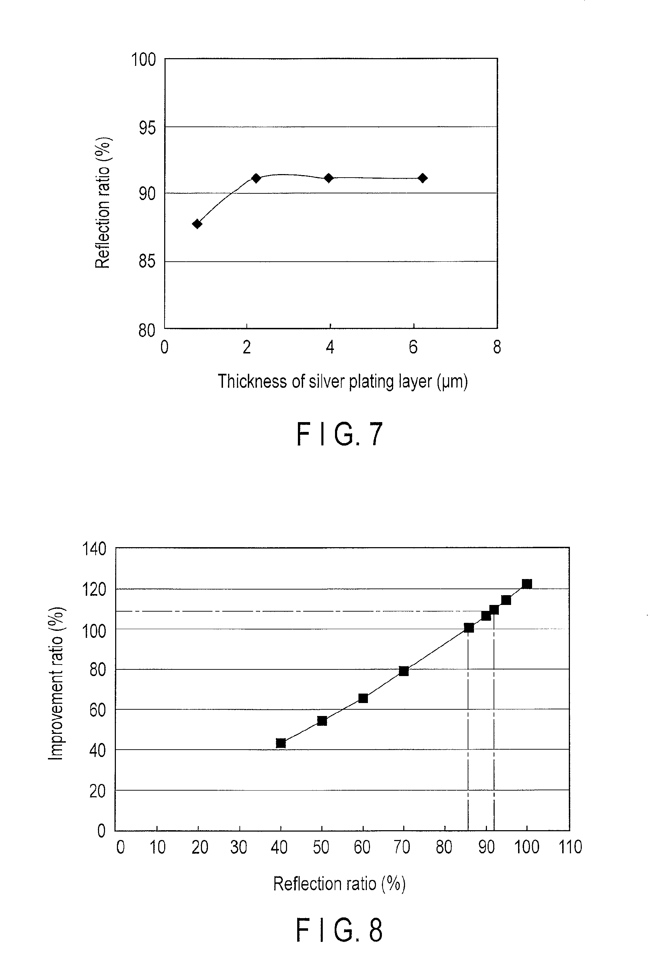

Next, the inventor(s) investigated influence of the thickness of the silver plating layer 33 on the reflection ratio of the light-reflecting layer 28. FIG. 7 illustrates the relationship between the thickness of the silver plating layer 33 and the reflection ratio of the light-reflecting layer 28. As is clear from FIG. 7, when the thickness of the silver plating layer 33 does not reach 2 µm, the reflection ratio is lower than 90%, at which sufficient brightness can be obtained as general illumination. In comparison with this, it was verified that the light-reflecting layer 28 in which the silver plating layer 33 has a thickness of 2 µm or more can maintain a high reflection ratio which is higher than 90%.

It is considered that this is because a silver plating layer 33 with a thickness that is less than 2 µm is too thin, and thus light emitted from the light-emitting diodes 41 passes through the silver plating layer 33.

Therefore, also in the case where the copper plating layer 31b is added to the copper layer 31a to increase smoothness of the underlayer of the light-reflecting layer 28, it is required that the thickness of the silver plating layer 33 which forms the light-reflecting surface 36 is set to 2 µm or more.

In addition, the inventor(s) inspected change of the light extracting efficiency in the case where the light-reflecting layer 28 had four layers and the light-emitting module 6 of Embodiment 1, in which the thickness of the silver plating layer 33 is 2 µm or more, was used as light source of the LED lamp 1.

FIG. 8 illustrates a result of comparison of the light extracting efficiency of an LED lamp which is provided with the light-emitting module of the comparative example with the reflection ratio of 88% to the light extracting efficiency the LED lamp 1 which is provided with the light-emitting module 6 of Embodiment 1 that includes the light-reflecting layer 28 with the reflection ratio of 92%. In FIG. 8, the light extracting efficiency of the LED lamp provided with the light-emitting module including the light-reflecting layer of the comparative example is evaluated as 100%.

As is clear from FIG. 8, the LED lamp 1 provided with the light-emitting module 6 of Embodiment 1 has light extracting efficiency of about 107%, which is improved by about 7% in comparison with that of the LED lamp of the comparative example. In addition, in view of improvement tendency of the light extracting efficiency, it was found that the light extracting efficiency was further improved and light emitted from the light-emitting diodes 41 could be effectively used as general illumination, as the reflection ratio of the light-reflecting layer 28 increased toward 100%.

On the other hand, according to the light-emitting module 6 of Embodiment 1, both the nickel plating layer 32 and the silver plating layer 33 which form the light-reflecting layer 28 are formed by electrolytic plating. Coating obtained by electrolytic plating has high single metal content by percentage. Therefore, it is possible to secure sufficient corrosion resistance of the light-reflecting layer 28.

In addition, the thickness T2 of the copper plating layer 31b is smaller than the thickness T1 of the copper layer 31a. Therefore, it is possible to shorten the work time required for forming the copper plating layer 31b, and reduce the cost required for the plating process.

Besides, when the copper layer 31a is formed of a copper foil, securing the thickness of the underlayer by covering the copper layer 31a with the copper plating layer 31b can more reduce the manufacturing cost of the light-reflecting layer 28, than the case of using a copper foil of a thickness including the copper plating layer 31b.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module **characterized by** comprising:
a module substrate (25);
a light-reflecting layer (28) which is superposed on the module substrate (25) and has a reflection ratio higher than the reflection ratio of the module substrate (25); and
a light-emitting element (41) which is mounted on the module substrate (25),
wherein the light-reflecting layer (28) includes a copper layer (31a), a copper plating layer (31b) which covers the copper layer (31a), and a metal layer (32, 33) which is superposed on the copper plating layer (31b) and reflects light emitted from the light-emitting element (41).

2. The light-emitting module of claim 1, **characterized in that**
the copper layer (31a) includes a surface (34) which is covered with the copper plating layer (31b), and the surface (34) of the copper layer (31a) is a rough surface which includes a plurality of depressions and projections.

3. The light-emitting module of claim 2, **characterized in that**
the copper plating layer (31b) has a thickness to fill the depressions and projections of the copper layer (31a).

4. The light-emitting module of claim 3, **characterized in that**
the copper plating layer (31b) is thinner than the copper layer (31a).

5. The light-emitting module of claim 1, **characterized in that**
the metal layer (32, 33) includes a nickel plating layer (32) which is superposed on the copper plating layer (31b), and a silver plating layer (33) which is superposed on the nickel plating layer (32), and the silver plating layer (33) forms a light-reflecting surface (36) which reflects the light emitted from the light-emitting element (41).

6. The light-emitting module of claim 4, **characterized in that**
the silver plating layer (33) has a thickness of 2 µm or more.

7. An illumination device **characterized by** comprising:
a body (2);
a light-emitting module (6) which is supported by the body (2); and
a lighting device (5) which is provided in the body (2) and lights the light-emitting module (6),
wherein the light-emitting module (6) includes:
a module substrate (25); a light-reflecting layer (28) which is superposed on the module substrate (25) and has a reflection ratio higher than the reflection ratio of the module substrate (25); and a light-emitting element (41) which is mounted on the module substrate (25), and the light-reflecting layer (28) includes a copper layer (31a), a copper plating layer (31b) which covers the copper layer (31a), and a metal layer (32, 33) which is superposed on the copper plating layer (31b) and reflects light emitted from the light-emitting element (41).

8. The illumination device of claim 7, **characterized in that**
the module substrate (25) includes a metal base (26) and an insulating layer (27) which is superposed on the base (26), and the copper layer (31a) of the light-reflecting layer (28) is superposed on the insulating layer (27).

9. The illumination device of claim 8, **characterized in that**
the body (2) is formed of metal and includes a support surface (7) on which the base (26) of the module substrate (25) is fixed.

10. The illumination device of claim 9, **characterized in that**
the module substrate (25) is thermally connected to the body (2).
